# EUROPÄISCHE PATENTSCHRIFT

(11) **EP 0 436 122 B1**
(45) Veröffentlichungstag und Bekanntmachung des Hinweises auf die Patenterteilung: **06.10.1993**
(21) Anmeldenummer: 90122794.2
(22) Anmeldetag: 29.11.1990
(51) Int. Cl.: C30B 30/08, C30B 7/00

(54) **Handhabung von Flüssigkeiten unter Schwerelosigkeit**
Handling fluids under low gravity conditions
Manipulation des fluides dans les conditions d'apesanteur

(30) Priorität: 13.12.1989 DE 3941099
(43) Veröffentlichungstag der Anmeldung: 10.07.1991
(73) Patentinhaber: DORNIER GMBH, D-88004 Friedrichshafen (DE)
(72) Erfinder: Sill, Karl-Hermann, Dr.-Ing., W-7777 Salem (DE); Lenski, Harald, Dr. Dipl.-Phys., W-7770 Überlingen (DE)
(74) Vertreter: Landsmann, Ralf, Dipl.-Ing.

(56) Entgegenhaltungen:
- US-A- 4 886 646
- PATENT ABSTRACTS OF JAPAN, Band 13, Nr. 529 (C-658)[3877], 27. November 1989; & JP-A-1 215 784
- H.U. WALTER: "Fluid sciences and materials science in space - a European perspective", 1988, Seiten 461-472, Springer-Verlag, Berlin, DE

## Beschreibung

Die Erfindung betrifft eine Vorrichtung und ein Verfahren zum Bedienen der Vorrichtung, um Flüssigkeiten insbesondere im Rahmen von Kristallzuchtexperimenten unter Schwerelosigkeit im Weltraum, zu handhaben.

Bei der "hanging drop"-Methode wird ein einseitig aufgehängter Tropfen mit einem Ausgangsvolumen V₁ einer nicht gesättigten Lösung langsam auf das kleinere Volumen V₂ verdampft, so daß sich eine gewünschte Übersättigung der gelösten Substanz einstellt, was zur Kristallisation dieser Substanz führt.

Diese Methode ist auch unter reduzierter Schwerkraft durchführbar, wobei sich deutlich größere Tropfen und damit auch größere Kristalle erzeugen lassen. Im Gegensatz zu einer erdgebundenen Anwendung muß eine weltraumtaugliche Vorichtung folgende Merkmale aufweisen:
- Die Ausgangslösung muß vor Beginn des Experiments dicht verschlossen aufbewahrt werden.
- Der Tropfen soll möglichst ohne Eingriff von Hand erzeugt werden können.
- Die Flüssigkeit muß nach Ende des Prozesses wiederum dicht verschlossen aufbewahrt werden, wobei die Flüssigkeit das Aufbewahrungsgefäß vollständig füllen muß, Gasblasen oder ähnliches sind zu vermeiden, da sonst die Kristalle bei der Landung zerstört werden können.

Darüberhinaus ist von großer Bedeutung, eine große Anzahl derartiger Prozesse gleichzeitig auf kleinem Raum durchführen zu können.

Der Erfindung liegt die Aufgabe zugrunde, eine Vorrichtung und ein Verfahren zum Betreiben der Vorrichtung anzugeben, mit der insbesondere unter Schwerelosigkeit die Tropfenbildung einer Flüssigkeit handhabbar ist.

Die Aufgabe wird durch die Vorrichtung nach Anspruch 1 und das Verfahren nach Anspruch 5 gelöst. Ausgestaltungen von Vorrichtung und Verfahren sind Gegenstand von Unteransprüchen.
Die Erfindung wird durch Figuren näher beschrieben.

Es zeigen:
Figur 1 in fünf Schritten den Verfahrensablauf
Figur 2 eine Vorrichtung zur Durchführung des Verfahrens.

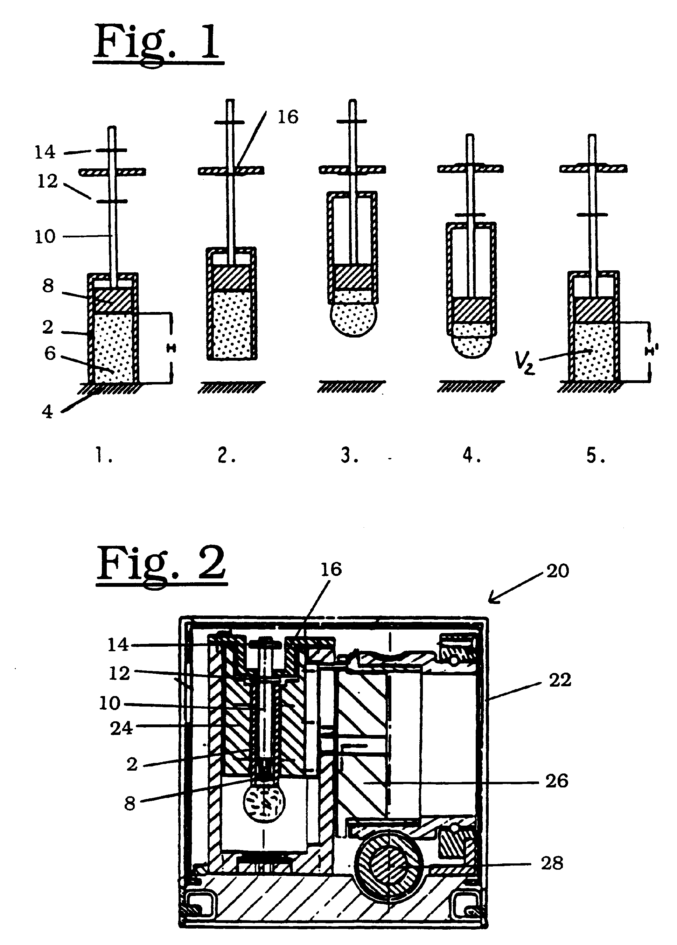

In Figur 1 ist die Verfahrensweise zum Betreiben einer erfindungsgemäßen Vorrichtung zum Erzeugen und Zurücksaugen von Tropfen am Ende eines Röhrchens gezeigt. Ein unten offenes Röhrchen 2, beispielsweise aus Glas, wird zum Abdichten mit dem offenen Ende auf eine elastische Einrichtung 4 gepreßt. Diese Einrichtung 4, vorzugsweise Silikongummi oder Polytetrafluorethylen (PTFE), benetzt die im Röhrchen 2 enthaltene Flüssigkeit 6 möglichst gering. Die Flüssigkeit 6, die zu Prozessbeginn in einem Volumen V1 vorliegt, wird im Röhrchen 2 durch einen Stempel 8 auf der Höhe H gehalten. Eine am Stempel 8 befestigte Schubstange 10 besitzt zwei voneinander beabstandete Anschläge, einen ersten Anschlag 12 und einen zweiten Anschlag 14, die auf jeweils entgegengesetzter Seite eines zu einem umgebenden Gehäuse gehörenden Bauteils 16 liegen. Die Schubstange 10 ist durch eine Aussparung in dem Bauteil 16 geführt.
Zur Erzeugung eines Tropfens wird das Röhrchen 2 von der Unterlage 4 abgehoben. Der im Röhrchen 2 befindliche Stempel 8 bewegt sich mit dem Röhrchen mit, so daß die Flüssigkeitshöhe H im Röhrchen konstant bleibt bis der Anschlag 12 an das Bauteil 16 herangeführt wird. Stößt der erste Anschlag 12 an das Bauteil 16 an und das Röhrchen 2 wird in gleicher Richtung weiterbewegt, so preßt der Stempel 8 die Flüssigkeit 6 aus dem Röhrchen 2 heraus und es bildet sich der gewünschte Tropfen.

Nach einer langsamen Verdampfung des Tropfens auf ein zweites, kleineres Volumen V₂ wird das Röhrchen 2 in der der ersten Bewegungsrichtung entgegengesetzter Richtung bewegt. Dabei bleibt der Stempel 8 zunächst in seiner Position innerhalb des Röhrchens 2, der erste Anschlag 12 löst sich von dem Bauteil 16 und der zweite Anschlag 14 wird an das Bauteil 16 herangeführt. Bei der Weiterbewegung des Röhrchens 2 stößt der Anschlag 14 an das Bauteil 16 und der Stempel 8 saugt den Tropfen vollständig in das Röhrchen 2 hinein. Das Röhrchen 2 wird wieder an die Einrichtung 4 angepreßt. Das im Röhrchen 2 befindliche Restvolumen V₂ weist eine kleinere Flüssigkeitshöhe H' auf.
Durch entsprechende Einstellung des Abstandes zwischen Anschlag 12 und Anschlag 14 läßt sich das vorher bekannte oder berechnete kleinere Volumen V₂ vollständig und blasenfrei zurücksaugen.

Die Figur 2 zeigt eine Vorrichtung 20 zur Erzeugung des Tropfens, die innerhalb eines Gehäuses 22 untergebracht ist. Das Röhrchen 2 ist in einer Einrichtung 24 eingespannt, die exzentrisch mit einem Antriebsrad 26 verbunden ist. Dieses Antriebsrad 26 mit außenliegendem Schneckengewinde ist mit dem Schneckengewinde einer Antriebseinheit 28 im Eingriff. Im Röhrchen 2 befindet sich die Schubstange 10 mit Stempel 8 und den beiden Anschlägen 12 und 14, die auf den beiden Seiten des Bauteils 16 liegen.

Der Vorteil dieser Erfindung besteht darin, daß mit nur einem Mechanismus das die Flüssigkeit enthaltene Röhrchen geöffnet und abgedichtet wird, ein Tropfen des Volumens V₁ erzeugt und anschließend ein Tropfen des geringeren Volumens V₂ zurückgesaugt wird, wobei die nach der Verdampfung vorliegende Lösung vollständig und ohne zusätzliches Gasvolumen eingeschlossen ist. Mit einem zentralen Antrieb lassen sich ohne zusätzliche individuelle Steuerung mehrere solche Einrichtungen gleichzeitig betätigen, wobei verschieden große Volumina gleichzeitig in verschiedenen Röhrchen realisiert werden können.

## Patentansprüche

1. Vorrichtung zur Handhabung einer Flüssigkeit, insbesondere unter Schwerelosigkeit in Raumfahrzeugen, mit einem Röhrchen, das die Flüssigkeit enthält, und einem im Röhrchen befindlichen Stempel mit Schubstange, **dadurch** **gekennzeichnet**, daß
- eine das offene Ende des Röhrchens (2) abdichtende, elastische, gering benetzende Einrichtung (4) mit einer Fläche größer als der Innendurchmesser des Röhrchens (2) vorgesehen ist,
- an der Schubstange (10) zwei Anschläge (12) und (14) angebracht sind, die in einem vorgegebenen Abstand zueinander einstellbar sind,
- ein Bauteil (16) mit Öffnung vorgesehen ist, an das die Anschläge (12) und (14) von entgegengesetzten Seiten anschlagen, wobei die Schubstange (10) durch die Öffnung geführt ist und
- Mittel vorgesehen sind, die mit dem Röhrchen (2) verbunden sind und eine senkrechte Bewegung des Röhrchens (2) von der Einrichtung (4) weg oder zu der Einrichtung (4) hin ermöglichen.

2. Vorrichtung nach Anspruch 1, **dadurch gekennzeichnet**, daß die abdichtende Einrichtung (4) aus Silikongummi oder Polytetrafluorethylen besteht.

3. Vorrichtung nach Anspruch 1, **dadurch gekennzeichnet**, daß für mehrere Röhrchen (2) ein gemeinsamer Antrieb vorgesehen ist.

4. Vorrichtung nach Anspruch 3, **dadurch gekennzeichnet**, daß die Röhrchen (2) verschiedene Volumina aufweisen.

5. Verfahren zur Handhabung einer Flüssigkeit, insbesondere unter Schwerelosigkeit in Raumfahrzeugen, **gekennzeichnet durch** die Verfahrensschritte
- Einstellen zweier Anschläge (12,14) an einer Schubstange (10) auf eine vorausberechnete, einem reduzierten Volumen V₂ entsprechende Höhe H',
- Abheben eines die Flüssigkeit (6) enthaltenen Röhrchens (2) von einer abdichtenden Einrichtung (4) bis zum Anstoß des ersten Anschlags (12) an ein Bauteil (16),
- Weiterbewegen des Röhrchens (2) in gleicher Richtung und Herausdrücken der Flüssigkeit (6) aus dem Röhrchen (2) durch einen Stempel (8), der über die Schubstange (10) mit den Anschlägen (12) und (14) verbunden ist unter Bildung eines Tropfens am offenen Ende des Röhrchens(2),
- Bewegen des Röhrchens (2) in entgegengesetzter Richtung bis zum Anstoß des zweiten Anschlags (14) an das Bauteil (16),
- Hineinsaugen des verkleinerten Tropfens durch Weiterbewegen des Röhrchens (2) bis zum vollständigen Absaugen des Tropfens und
- blasenfreies Absetzen und Anpressen des Röhrchens (2) auf die abdichtende Einrichtung (4).

## Claims

1. Device for handling a fluid, in particular under conditions of zero gravity in spacecraft, having a small tube containing the fluid, and a plunger which is located in the small tube and has a thrust rod, characterised in that:
- a resilient, slightly dampening device (4) which seals the open end of the small tube (2) and has a surface which is greater than the internal diameter of the small tube (2) is provided;
- two abutment stops (12) and (14), which can be set at a predetermined distance from one another, are mounted on the thrust rod (10);
- a component (16) having an aperture, on which component the abutments stops (12) and (14) strike from opposite sides, wherein the thrust rod (10) is guided through the aperture; and
- means are provided which are connected to the small tube (2) and which allow the small tube (2) to move towards or away from the device (4) at right angles.

2. Device according to Claim 1, characterised in that the sealing device (4) consists of silicone rubber or polytetrafluoroethylene.

3. Device according to Claim 1, characterised in that a common drive is provided for a plurality of small tubes (2).

4. Device according to claim 3, characterised in that the small pipes (2) have different volumes.

5. Process for handling a fluid, in particular under conditions of zero gravity in spacecraft, characterised by the following process steps:
- setting two abutment stops (12,14) on a drive rod (10) at a precalculated height H', corresponding to a reduced volume V₂;
- lifting a small tube (2) containing the fluid (6) away from a sealing device (4) until the first abutment stop (12) strikes against a component (16);
- moving the small tube (2) further in the same direction and pressing the fluid (6) out of the small pipe (2) by means of a plunger (8), which is connected to the abutment stops (12) and (14) by means of the thrust rod (10), forming a drop at the open end of the small tube (2);
- moving the small tube (2) in the opposite direction until the second abutment stop (14) strikes against the component (16);
- drawing in the drop, which has reduced in size, by moving the small tube (2) further until the drop is completely drawn off; and
- removing the small tube (2) from the sealing device (4) and pressing it thereon without bubbles.

## Revendications

1. Dispositif de manipulation d'un fluide, en particulier en apesanteur à bord de vaisseaux spatiaux, comprenant un capillaire contenant le fluide, et un poinçon muni d'une tige de poussée situé dans le capillaire, caractérisé en ce que
- un organe (4) mouillant faiblement, élastique, colmatant l'extrémité ouverte du capillaire (2) est prévu possédant une surface supérieure au diamètre interne du capillaire (2),
- sur la tige de poussée (10) sont fixées deux butées (12) et (14), qui sont réglables à un écartement mutuel prédéterminé,
- un élément (16) possédant une ouverture est prévu, que les butées (12) et (14) heurtent depuis des côtés opposés, la tige de poussée (10) étant guidée par l'ouverture, et
- des moyens sont prévus, qui sont reliés au capillaire (2) et permettent un mouvement vertical de va-et-vient du capillaire (2) depuis ou vers l'organe (4).

2. Dispositif selon la revendication 1, caractérisé en ce que le dispositif d'étanchéité (4) est constitué de caoutchouc au silicone ou de polytétrafluoréthylène.

3. Dispositif selon la revendication 1, caractérisé en ce que, pour plusieurs capillaires (2), un entraînement commun est prévu.

4. Dispositif selon la revendication 3, caractérisé en ce que les capillaires (2) présentent des volumes différents.

5. Procédé de manipulation d'un fluide, en particulier en apesanteur à bord de vaisseaux spatiaux, caractérisé par les étapes consistant à :
- régler deux butées (12, 14) sur une tige de poussée (10) d'une hauteur H' précalculée, correspondant à un volume réduit V₂,
- soulever un capillaire (2) contenant le fluide (6) depuis un organe d'étanchéité (4) jusqu'à ce que la première butée (12) heurte un élément (16),
- déplacer de nouveau le capillaire (2) dans la même direction et expulserle fluide (6) du capillaire (2) au moyen d'un poinçon (8), qui est relié aux butées (12) et (14) par la tige de poussée (10), en formant une goutte à l'extrémité ouverte du capillaire (2),
- déplacer le capillaire (2) dans la direction opposée jusqu'à ce que la seconde butée (14) heurte l'élément (16),
- aspirer la goutte réduite en continuant de déplacer le capillaire (2) jusqu 'à aspiration complète de la goutte, et
- déposer et presser le capillaire (2) exempt de bulles sur l'organe d'étanchéité (4).
